**Europäisches Patentamt**

**European Patent Office**

**Office européen des brevets**

(19)

(11) Veröffentlichungsnummer : **0 191 178 B1**

(12) **EUROPÄISCHE PATENTSCHRIFT**

(45) Veröffentlichungstag der Patentschrift :
02.03.88

(21) Anmeldenummer : 85115729.7

(22) Anmeldetag : 10.12.85

(51) Int. Cl.⁴ : **B 23 K 11/24**, H 02 H 7/12//
**H01F31/00**

(54) **Sättigungsüberwachungsanordung für eine Frequenzwandler-Schweisseinrichtung.**

(30) Priorität : **14.12.84 CH 5945/84**

(43) Veröffentlichungstag der Anmeldung :
**20.08.86 Patentblatt 86/34**

(45) Bekanntmachung des Hinweises auf die Patenterteilung : **02.03.88 Patentblatt 88/09**

(84) Benannte Vertragsstaaten :
**CH DE FR GB IT LI NL SE**

(56) Entgegenhaltungen :
CH-A- 441 545
K. MEYER: "Sättigungsvorgänge in periodisch geschalteten einphasigen Transformatoren zur WiderstandschweiBung und Verfahren zum Schutz stromrichtergesteuerter WiderstandschweiBanlagen",
1962 TECHNISCHE UNIVERSITÄT, Berlin, Seiten 55 -
64 (Kapitel 3.4 und 4)

(73) Patentinhaber : **ELPATRONIC AG**
**Baarerstrasse 117**
**CH-6300 Zug (CH)**

(72) Erfinder : **Tengler, Hermann**
**Tramstrasse 5**
**CH-5033 Buchs (CH)**
Erfinder : **Mettler, Paul**
**Wagenrainstrasse 23**
**CH-5620 Bremgarten (CH)**

(74) Vertreter : **Hotz, Klaus, Dipl.-El.-Ing. / ETH**
**c/o SOUDRONIC AG Industriestrasse 35 Postfach 11**
**CH-8962 Bergdietikon (CH)**

## Beschreibung

Die Erfindung betrifft eine Anordnung für eine Frequenzwandler-Schweißeinrichtung zur Überwachung der Sättigung des Schweißtransformators, der aus durch ein Steuergerät gesteuerten Leistungshalbleitern positive und negative Stromimpulse empfängt und einen Kern mit drei Schenkeln aufweist, von denen der Mittelschenkel die Primär- und die Sekundärwicklung trägt.

Außerdem betrifft die Erfindung ein Verfahren zur Steuerung einer Frequenzwandler-Schweißeinrichtung.

Es ist eine Kontrolleinrichtung für Widerstandsschweißeinrichtungen bekannt (DE-PS 11 25 573), bei der die Spannung am Schweißtransformator überwacht wird. Beim Betrieb von Widerstandsschweißeinrichtungen, die mit Dampf- oder Gasentladungsgefäßen versehen sind, wird gefordert, den Schweißstrom und die Entladungsgefäße zu überwachen, da schon bei Ausfall eines Gefäßes sich einerseits ein zur Herstellung einer ordentlichen Schweißstelle unzureichender Strom einstellt und andererseits eine asymmetrische Magnetisierung des angeschlossenen Schweißtransformators und damit unter Umständen seine Zerstörung erfolgt. Bei dieser bekannten Kontrolleinrichtung kommen aus praktischen Erwägungen zur Überwachung des Schweißvorganges nur der Primärstrom und die Primärspannung in Frage. Zu diesem Zweck wird ein Hilfstransformator verwendet, der parallel an die Primärwicklung des Schweißtransformators angeschlossen ist, und mittels einer Reihenschaltung eines Relaiskreises und eines steuerbaren Schaltelements wird das Vorhandensein der Spannung geprüft und hiervon die Entscheidung « Zündung erfolgt » oder « Zündung nicht erfolgt » abgeleitet. Mit dieser bekannten Kontrolleinrichtung läßt sich der Schweißtransformator nur vor unzulässigen Dauerströmen schützen, die durch Sättigung seines Eisenkernes infolge Ausfalles eines Gefäßzweiges oder bei grob unsymmetrischem Phasenanschnitt entstehen können. Die Sättigung an sich, die auch verursacht werden kann, wenn kein Gefäßzweig ausgefallen oder kein grob unsymmetrischer Phasenanschnitt vorhanden ist, läßt sich mit dieser bekannten Kontrolleinrichtung offenbar nicht vermeiden. Außerdem ist bei der bekannten Kontrolleinrichtung nachteilig, daß von einer Messung im Primärkreis ausgegangen wird, um auf das Verhalten des Transformators zu schliessen, wogegen die maßgebendere Größe dessen Übertragungseigenschaften (Sekundärspannung oder Sekundärstrom) wären.

Um eine bessere Aussage über das Verhalten des Transformators zu erzielen, wird bei einer bekannten Anordnung zum Schutz von Transformatoren und deren Schaltgeräten (DE-AS 10 29 457) der magnetische Fluß des Transformators in einer sättigbaren Drossel näherungsweise nachgebildet. Diese bekannte Anordnung soll sicherstellen, daß durch phasenrichtiges Ein- und Ausschalten bestimmte Maximalwerte des Einschaltstromes eingehalten werden, indem unter anderem dafür gesorgt wird, daß der Transformator stets mit der Halbwelle der Spannung eingeschaltet wird, die zu der zuletzt angelegten Halbwelle entgegengesetzt gerichtet ist. Außerdem soll verhindert werden, daß bei der Verwendung der sogenannten Antiparallelschaltung der Gefäße ein Gefäß aussetzt und dadurch nur noch die Halbwellen einer Richtung auf den Transformator geschaltet werden. In diesem Fall würde nämlich nach einer bestimmten Zahl von Halbwellen die Sättigung des Transformators eintreten. Die bekannte Anordnung bezweckt deshalb den Transformator so rechtzeitig abzuschalten, daß der Transformator und die Schaltgeräte vor dem Fortdauern der unter Umständen sehr hohen Sättigungsströme geschützt werden. Die Anordnung enthält eine den Transformator parallel geschaltete Reihenschaltung aus einem Widerstand und einer sättigbaren Drossel, deren Sättigungsfluß dem Spannungszeitintregral einer Halbwelle mindestens gleich sein muß, so daß bei Ausbleiben einer Halbwelle oder bei falschem Einschaltzeitpunkt die Drossel gesättigt wird und am Widerstand ein Spannungsimpuls entsteht, der zur Einleitung eines Auslösevorgangs benutzt wird, beispielsweise zum Abschalten der Zündeinrichtung von Gasentladungsgefäßen. Nachteilig ist bei dieser bekannten Anordnung, daß sich der Sättigungszustand des zu schützenden Transformators nur näherungsweise erfassen läßt, weil die sättigbare Drossel an den Primärkreis des Transformators angeschlossen ist und außerdem von dem Verhalten der Drossel auf das Verhalten des Transformators geschlossen werden muß.

Es ist zwar bereits eine Versuchsanordnung für Schweißtransformatoren bekannt geworden (Meyer, K. : Sättigungsvorgänge in periodisch geschalteten, einphasigen Transformatoren zur Widerstandschweißung und Verfahren zum Schutz stromrichtergesteuerter Widerstandsschweißanlagen, Dissertation, Technische Universität Berlin, 1962), bei der eine zweite Sekundärwicklung auf dem Kern eines Schweißtransformators zur Flußerfassung benutzt wird. Diese Versuchsanordnung dient jedoch lediglich zur Untersuchung des elektrischen Verhaltens von Hypersil-Schweißtransformatoren und führte zu dem Ergebnis, daß bei solchen Schweißtransformatoren die Sättigung durch Schwankungen der Betriebsgrößen in der Schweißpraxis unvermeidlich ist, weswegen auch von der Registrierung der Sättigung keine Entscheidung abgeleitet werden konnte. Mit der bekannten Versuchsanordnung ließe sich somit unter Umständen zwar der Sättigungszustand des Schweißtransformators überwachen, mit Rücksicht auf den Schweißbetrieb mußte jedoch dessen Sättigung zugelassen werden. Die bekannte Versuchsanordnung führte deshalb dazu, daß bei dem Hypersil-Schweißtransformator wieder auf die Erfassung der Primärspannung zurückgegriffen wurde, was mit den oben dargelegten Nachteilen verbunden ist und sich nicht bei einem Schweißtransformator anwenden läßt, bei dem die Sättigung überhaupt vermieden werden soll.

2

0 191 178

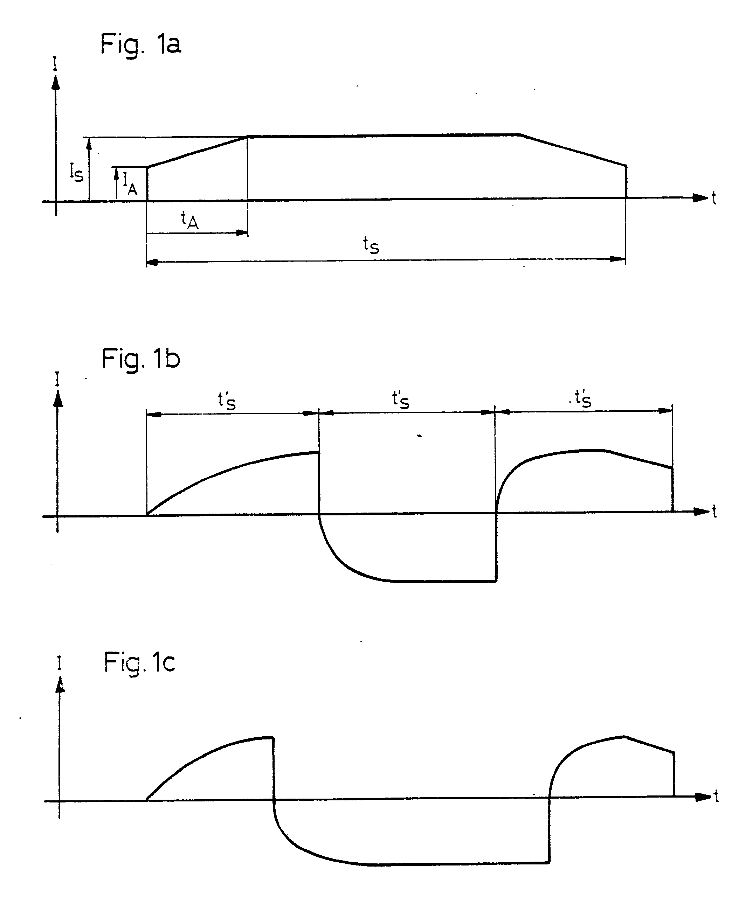

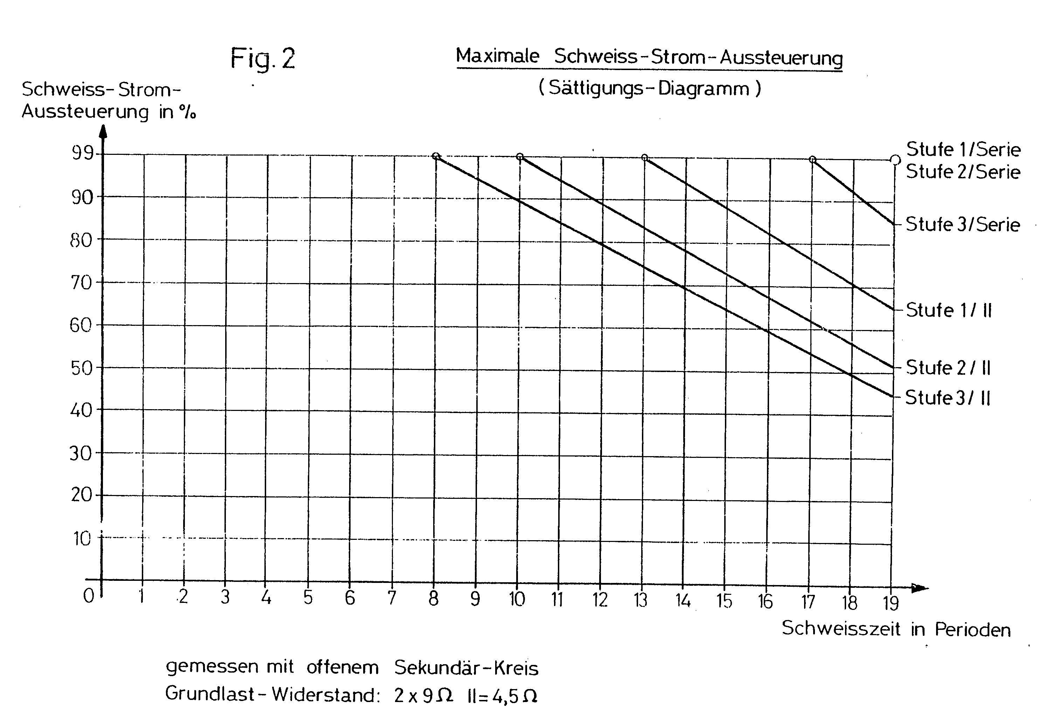

Bei Frequenzwandler-Schweißeinrichtungen treten noch weitere Probleme auf, die sich mit den vorstehend erläuterten bekannten Einrichtungen und Anordnungen nicht beseitigen lassen. Zu Erläuterungszwecken wird im folgenden auf die Fig. 1a, 1b und Fig. 2 Bezug genommen, die einen Schweißstromeinzelimpuls mit Stromanstieg und Stromabfall ; den gleichen Impuls, aber bei Frequenzwandlersteuerung ; bzw. ein Sättigungsdiagramm für die maximale Schweißstromaussteuerung zeigen.

Für einen einzelnen Schweißstromimpuls stehen ein bestimmter Schweißstrom $I_s$ und eine Schweißzeit $t_s$ zur Verfügung. Der Benutzer des Schweißmaschine muß die Schweißzeit $t_s$ so wählen, daß der Schweißtransformator nicht in den Sättigungsbereich gelangt, weil in diesem der Primärstrom über seinen gewünschten Wert ansteigen und die gesteuerten Leistungshalbleiter, über die der Schweißtransformator mit Stromimpulsen versorgt wird, beschädigen könnte. Der Benutzer einer Gleichrichtermaschine wählt deshalb anhand des Diagramm nach Fig. 2 die Länge des Schweißimpulses nach Fig. 1a und der Benutzer einer Frequenzwandlermaschine wählt die Zeitdauer $t_s'$ eines Impulses nach Fig. 1b, das heißt, er teilt den Einzelimpuls nach Fig. 1a in dem hier gewählten Beispiel in drei gleichlange Einzelimpulse abwechselnder Polarität auf, wobei aber die erlaubte Zeit gemäß dem Diagramm nach Fig. 2 nicht überschritten werden darf. Wenn der Benutzer beispielsweise gemäß dem Diagramm nach Fig. 2 von der Stufe 3/Serie auf die Stufe 1/parallel umschaltet, dann muß er auch die Schweißzeit um vier Netzperioden verkürzen, damit der Schweißtransformator nicht in die oberhalb von 99 % Schweißstromaussteuerung angenommene Sättigung gelangt. Da das Steuerungsprogramm in dem Steuergerät, in das der Maschinenbenutzer außer dem Schweißstrom und der Schweißzeit zusätzlich noch die Vorpreßzeit, die Nachpreßzeit, die Abhebezeit, eine eventuelle Pausenzeit, die Impulszahl, den Anfangsstrom und die Anstiegszeit eingibt, keine eingebaute Sicherung enthält, welche die Maschine bei unzulässiger Wahl dieser Parameter oder bei einer Netzüberspannung vor Überlastung und die gesteuerten Leistungshalbleiter vor einer Zerstörung durch zu hohe Sättigungsströme schützt, ist als Schutzmaßnahme in den Transformatordiagrammen eine gewisse Sicherheitsreserve eingebaut, die aber eine optimale Ausnutzung des Schweißtransformators verhindert.

Weiter muß der Benutzer bei der Schweißstromsteuerung nicht nur die Eigenschaften des Schweißtransformators berücksichtigen, sondern auch die Anforderungen des Materials beachten. Für die zu schweißenden Materialien gibt es Erfahrungswerte in Tabellenform. Die zulässigen Parameter muß der Benutzer aus Diagrammblättern herauslesen, die für jeden Maschinentyp verschieden sind. Das ist umständlich und schließt die Gefahr einer falschen Parameterwahl, wie beispielsweise der falschen Schweißstufe, nicht aus. Bei groben Fehlern in der Parameterwahl kann schließlich die Sicherheitsreserve überschritten werden, ohne daß der Benutzer das rechtzeitig merkt. Das ließe sich nur durch eine Sättigungsüberwachung erreichen, für die die oben beschriebenen bekannten Anordnungen und Einrichtungen aber aus den dargelegten Gründen nicht geeignet sind.

Bei der herkömmlichen Schweißstromsteuerung einer Frequenzwandlermaschine muß stets mit gleichlangen Teilimpulsen wechselnder Polarität gearbeitet werden, weil sich nur durch gleichlange Impulse abwechselnder Polarität verhindern läßt, daß der Transformator in die Sättigung gelangt. Wenn aber der Maschinenbenutzer die Impulsaufteilung fehlerhaft durchführt, beispielsweise zwei Teilimpulse statt drei Teilimpulsen wählt, dann ist jeder Teilimpuls zu lang, so daß der Schweißtransformator trotzdem in die Sättigung gelangen kann, obwohl mit gleichlangen Impulsen gearbeitet wird (vorausgesetzt, daß die genannte Sicherheitsreserve überschritten wird).

Aufgabe der Erfindung ist es, eine Anordnung der eingangs genannten Art so auszubilden, daß sie das Erreichen der Sättigung im Schweißtransformator sicher erkennt und die Steuerung der Frequenzwandler-Schweißeinrichtung so verbessert, daß sie von der Zuverlässigkeit der Parametereingabe durch einen Benutzer wesentlich weniger abhängig ist und eine optimale Ausnutzung des Schweißtransformators gestattet.

Die Lösung dieser Aufgabe ist gemäß der Erfindung gekennzeichnet durch eine Meßwicklung, die auf zwei von dem Mittelschenkel ausgehende Joche aufgeteilt ist und deren beide Meßwicklungsteile in Reihe geschaltet sind, durch einen an die Meßwicklung angeschlossenen Generator zum Erzeugen einer Meßspannung bestimmter Frequenz und durch eine parallel zu dem Generator an die Meßwicklung angeschlossene Detektorschaltung, die zur Erzeugung eines die Ansteuerung der Leistungshalbleiter blockierenden Signals durch einen Vergleich zwischen der Meßspannung und einer Referenzspannung feststellt, wann der induktive Widerstand der Meßwicklung einen auf die Sättigung bezogenen Schwellenwert unterschreitet.

Die Anordnung nach der Erfindung liefert eine genaue Angabe über das Sättigungsverhalten des Kerns des Schweißtransformators und schaltet bei Erreichen eines Sättigungsbezogenen Schwellenwertes die Zündung der Leistungshalbleiter ab. Damit ist eine Stromeingabe nach Fig. 1a möglich (gleichstrommäßig), da die Aufteilung in Impulse entsprechend der maximalen Transformatorausnutzung bis an die Sättigung nun automatisch gesteuert werden kann. Da die an der Meßwicklung abgegriffene Spannung mit zunehmender Annäherung an die Sättigung abnimmt, läßt sich durch entsprechende Wahl des sättigungsbezogenen Schwellenwertes mit Sicherheit verhindern, daß der Schweißtransformator in die Sättigung gelangt. Da gemäß der Erfindung die Schweißtransformatorsättigung kontrolliert werden kann, sind auch viel kleinere Sicherheitsreserven nötig. Der Schweißtransformator kann also optimal ausgenutzt werden.

In der Ausgestaltung der Erfindung nach den Ansprüchen 2 bis 5 wird mit Sicherheit vermieden, daß

3

das Meßergebnis durch Netzstörungen nachteilig beeinflußt wird.

In der Ausgestaltung der Erfindung nach den Ansprüchen 6 und 7 wird im Schweißbetrieb verhindert, daß sich bei dem sättigungsabhängigen Ein- und Ausschalten ein schwingungsfähiger Zustand einstellt.

Die Verwendung der erfindungsgemäßen Anordnung in einem Steuerungsverfahren gemäß Anspruch 8 führt zu einer überraschenden Vereinfachung der Bedienung und der Steuerung der Frequenzwandler-Schweißeinrichtung. Die Bedienung hinsichtlich der vorzuwählenden Parameter für die Schweißstromsteuerung wird vereinfacht, weil nur noch der Schweißstrom und die gesamte Schweißzeit vorgewählt zu werden brauchen, nicht aber die Aufteilung der Schweißzeit in eine bestimmte Anzahl von Teilschweißimpulsen, deren Anzahl bei dem herkömmlichen Steuerungsverfahren anhand des Sättigungsdiagramms so gewählt werden muß, daß der Schweißtransformator nicht in den Sättigungsbereich gelangt. Da jeder Schweißimpuls im Rahmen der vorgewählten Schweißzeit so lange dauert, bis der sättigungsbezogene Schwellenwert erreicht ist, legt die Steuerung selbsttätig die Aufteilung der Schweißzeit in Einzelimpulse beliebiger Länge fest. Die Frequenzwandler-Schweißeinrichtung ist also von der Zuverlässigkeit der Parametereingabe durch einen Benutzer bei Verwendung der Sättigungsüberwachungsanordnung nach der Erfindung wesentlich weniger abhängig.

Damit die Sättigungsüberwachungsanordnung nach der Erfindung in die Steuerung einwirken kann, ist es lediglich erforderlich, ein digitales Signal mit den Zuständen « sättigungsbezogener Schwellenwert nicht erreicht » und « sättigungsbezogener Schwellenwert erreicht » zur Verfügung zu stellen. Zu diesem Zweck wird in der Detektorschaltung ein Gleichspannungssignal, das umgekehrt proportional zur Sättigung ist, durch einen Komparator mit einem Referenzwert verglichen. Ist die Gleichspannung größer als der Referenzwert, liegt am Ausgang des Komparators eine logische 1 an, ist die Spannung kleiner, gibt er eine logische 0 ab. Durch einen Invertierer hinter dem Komparator können die logischen Signalwerte für die richtige Wertzuordnung vertauscht werden, so daß dann gilt « 0 »= « sättigungsbezogener Schwellenwert nicht erreicht » und « 1 »= sattigungsbezogener Schwellenwert erreicht ». Die üblicherweise bereits vorhandene Schweißstromsteuerung benötigt dann lediglich einen zusätzlichen digitalen Eingang für die vorgenannten Binärsignale und einen digitalen Ausgang für eine Alarmanzeige, sie benötigt aber nicht länger einen Impulszähler, der feststellt, ob eine vorgewählte Impulszahl erreicht ist, da keine Impulszahl mehr vorzuwählen ist.

Ein Ausführungsbeispiel der Erfindung wird im folgenden unter Bezugnahme auf die Zeichnungen näher beschrieben. Es zeigen.

die Fig. 1a-1b Erläuterungsdiagramme.

Fig. 2 ein Sättigungsdiagramm eines stufenweise umschaltbaren Schweißtransformators.

Fig. 3 ein Schaltbild einer Frequenzwandler-Schweißmaschine mit einer Sättigungsüberwachungsanordnung nach der Erfindung.

Fig. 4 eine ausführlichere Darstellung des Kerns des Schweißtransformators nach Fig. 3 mit der magnetischen Flußaufteilung.

Fig. 5 eine ausführlichere Darstellung der an den Schweißtransformator nach Fig. 3 angeschlossenen Sättigungsüberwachungsanordnung nach der Erfindung.

Fig. 6 Kurvendiagramme, die im Betrieb der Frequenzwandlermaschine nach Fig. 3 bei Verwendung der Sättigungsüberwachungsanordnung nach der Erfindung gemessen worden sind.

Fig. 7 ein Flußdiagramm der Steuerung einer Frequenzwandler-Schweißmaschine ohne die Sättigungsüberwachungsanordnung nach der Erfindung.

Fig. 8 ein Flußdiagramm der Steuerung einer Frequenzwandler-Schweißmaschine mit der Sättigungsüberwachungsanordnung nach der Erfindung und

Fig. 9 einen ausführlichen Schaltplan einer in der Sättigungsüberwachungsanordnung nach der Erfindung enthaltenen Detektorschaltung.

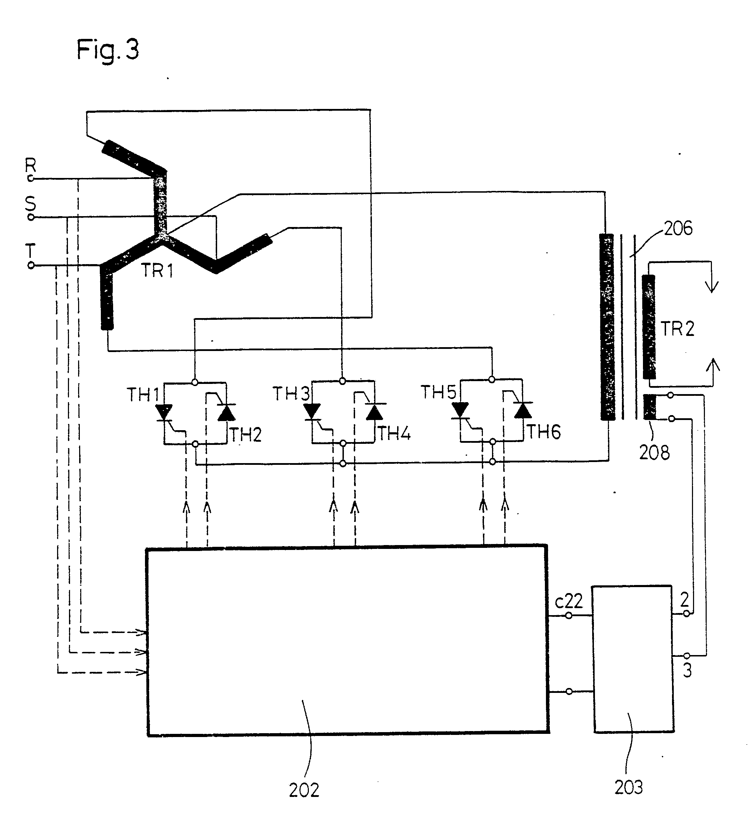

Fig. 3 zeigt eine Frequenzwandler-Schweißmaschine mit einem in Zick-Zack geschalteten Dreiphasen-Netztransformator TR1, auf dessen Ausgangsseite drei Paare gesteuerter Halbleiter in Form von Thyristoren TH1-TH6 in Antiparallelschaltung angeordnet sind. Durch wechselseitige Gleichrichtung werden dem Schweißtransformator TR2 positive bzw. negative Stromimpulse zugeführt. Die Amplitude dieser Ströme, ihre Zeitdauer sowie ihr zeitlicher Verlauf werden durch ein präzise arbeitendes Digital-Steuergerät 202 eingestellt, welches mittels entsprechender Steuersignale die drei Thyristorpaare ansteuert. Um eine Sättigung des Schweißtransformators TR2 zu vermeiden und diesen im magnetischen Gleichgewicht zu halten, sorgt das Steuergerät außerdem für die richtige Polarität der aufeinanderfolgenden Impulse. Dabei wird das Steuergerät 202 zusätzlich durch eine Sättigungsüberwachungsanordnung unterstützt, die aus einer elektronischen Schaltung 203 und aus einer zusätzlich auf dem Kern 206 des Schweißtransformators TR2 angeordneten Meßwicklung 208 besteht.

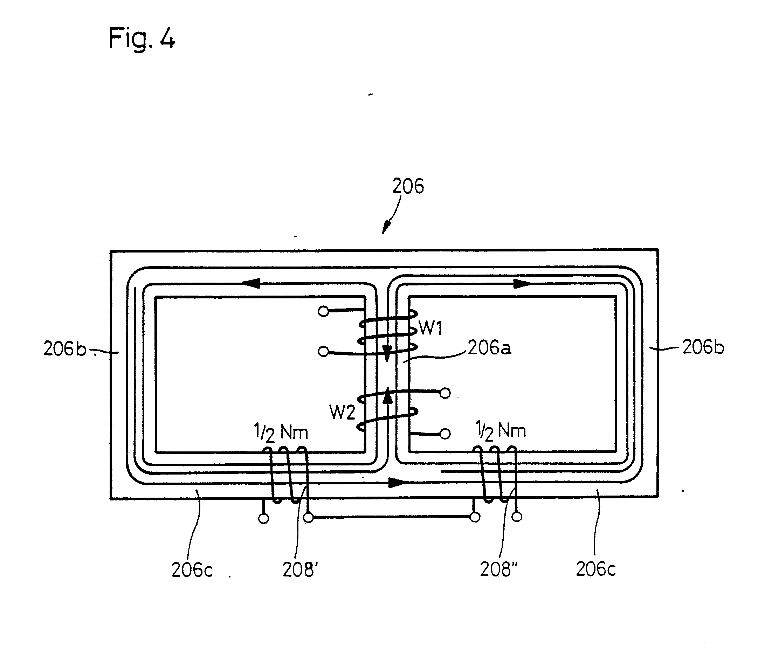

In Fig. 4 ist der Kern 206 des Schweißtransformators TR2 mit seinen Wicklungen ausführlicher dargestellt. Der Kern 206 hat einen Mittelschenkel 206a und zwei Außenschenkel 206b, die durch Joche 206c miteinander verbunden sind. Auf dem Mittelschenkel 206a sind die Primärwicklung W1 und die Sekundärwicklung W2 auf dargestellte Weise angeordnet. Die Meßwicklung 208 besteht aus zwei gleichen Meßwicklungsteilen 208′ und 208″, die jeweils auf einem der Joche 206c beiderseits des Mittelschenkels 206a angeordnet und in Reihe geschaltet sind. Jedes Joch 206c ist also mit der halben Windungszahl Nm der Meßwicklung versehen. An die Meßwicklung 208 wird auf im folgenden noch näher erläuterte Weise eine Meßspannung angelegt. Die Flüsse, die durch die Meßwicklungsteile 208′ und 208″

erzeugt werden, heben sich in dem Mittelschenkel 206a auf, so daß die Meßspannung den Schweißstrom des Transformators nicht beeinflußt. Der Fluß, der durch die Primärwicklung W1 induziert wird, erzeugt keine resultierende Spannung in der Meßwicklung, da sich die Spannungen an den Wicklungsteilen 208', 208" gegenseitig aufheben. Energieübertragung und Signalübertragung sind also vollständig entkoppelt.

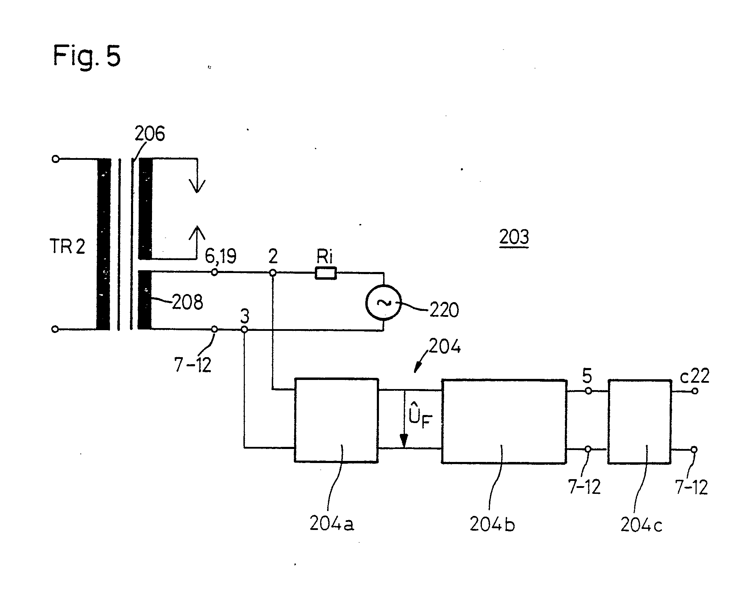

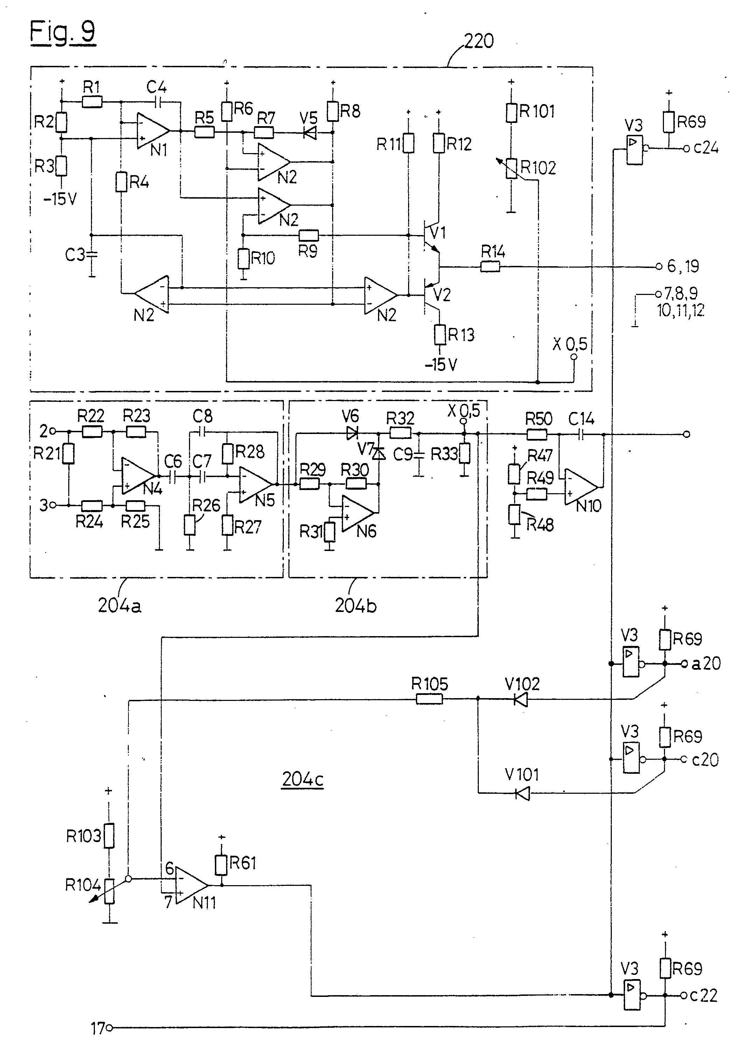

Fig. 5 zeigt eine ausführlichere Darstellung der Sättigungsüberwachungsanordnung. An die Meßwicklung 208' ist die elektronische Schaltung 203 angeschlossen, die eine Detektorschaltung 204 und einen Signalfrequenzgenerator 220 enthält. Der Signalfrequenzgenerator 220 ist mit der Meßwicklung 208 verbunden, hat einen Innenwiderstand Ri von etwa 100 Ohm und erzeugt eine Rechteckspannung mit einer Signalfrequenz, die einen Wert in einem Bereich von 5 bis 20 kHz und vorzugsweise einen Wert von etwa 10 kHz hat. Die Meßwicklung 208 hat einen hier vernachlässigbaren Ohmschen Widerstand und einen induktiven Widerstand, der von dem magnetischen Zustand des Kernes 206, vom Kernmaterial und von der Windungszahl abhängig ist. An die Verbindungen zwischen dem Signalfrequenzgenerator 220 und der Meßwicklung 208 ist die Detektorschaltung 204 mit ihrem Eingang (Klemmen 2 und 3) parallel angeschlossen und der Ausgang der Detektorschaltung 204 (Klemmen c22, 7-12) ist mit dem Steuergerät 202 verbunden (Fig. 3). Die Detektorschaltung 204 besteht aus einem Hochpaßfilter 204a, das alle Frequenzen unterhalb von 1 kHz sperrt und alle Frequenzen oberhalb von 1 kHz durchläßt, aus einem Amplitudendemodulator 204b und aus einer Diskriminatorschaltung 204c. Das Filter 204a verhindert das Eindringen von Netzstörungen über den Schweißtransformator TR2 in die Detektorschaltung 204. Das Filter 204a liefert am Ausgang eine Sinusspannung mit einer Frequenz entsprechend der Generatorsignalfrequenz. Diese Spannung wird an dem Spannungsteiler, den der Innenwiderstand Ri und die Meßwicklung 208 bilden, abgegriffen und stellt die resultierende Spannung dar, die an der Meßwicklung 208 noch verfügbar ist. Wenn der Kern 206 durch die in der Primär- und in der Sekundärwicklung des Schweißtransformators TR2 fließenden Ströme gesättigt wird, verändert sich der magnetische Zustand des Kerns, und je mehr dieser gesättigt wird, um so kleiner wird der magnetische Widerstand der Spule und somit auch die Amplitude der Spannung, die an der Meßwicklung 208 abgegriffen wird. Der Amplitudendemodulator 204b liefert an seinem Ausgang eine Gleichspannung, die zu der Amplitude Signalfrequenz-Sinusspannung $\hat{u}_F$ proportional ist. Die Amplitude der Spannung $\hat{u}_F$ ist ihrerseits proportional zu dem magnetischen Widerstand der Meßwicklung 208, der direkt durch der Sättigungsszustand des Kernes 206 beeinflußt wird. Je mehr der Kern 206 gesättigt wird, um so mehr magnetische Feldlinien gehen durch die Luft, wodurch der magnetische Widerstand der Meßwicklung 208 um so kleiner wird, so daß schließlich nur noch der kleine Kupferwiderstand derselben wirksam ist. Die Diskriminatorschaltung 204c ist weiter unten mit Bezug auf Fig. 9 beschrieben.

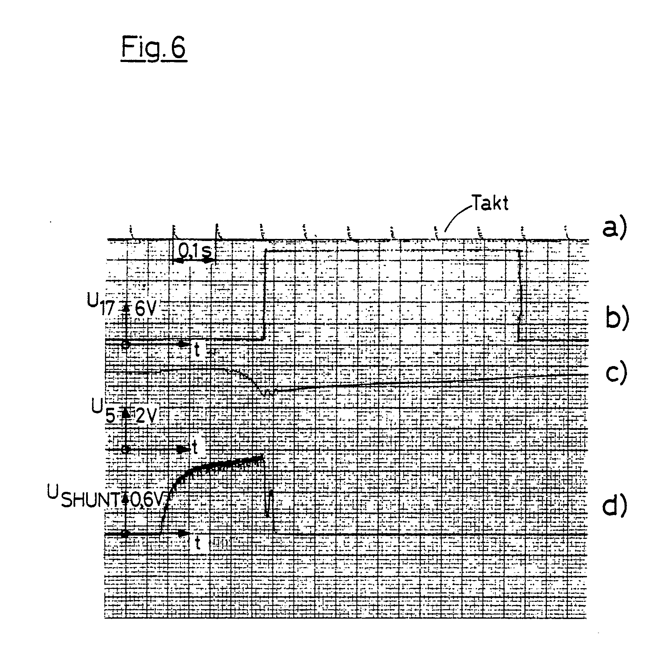

Fig. 6 veranschaulicht die Arbeitsweise der Sättigungsüberwachungsanordnung am Beispiel einer einimpulsigen Schweißung. Die Kurve in Fig. 6a zeigt Taktsignale, die durch einen in dem Steuergerät 202 enthaltenen Taktgeber (nicht dargestellt) erzeugt werden. Die Kurve 6d zeigt den Schweißstrom $I_s$ (gemessen als Spannung u an einem Shunt). Die Kurve 6c zeigt das Ausgangssignal des Amplitudendemodulators 204b. Aus dem linken Teil von Fig. 6 ist somit zu erkennen, daß mit zunehmendem Schweißstrom $I_s$ das Ausgangssignal des Amplitudendemodulators zunächst pratisch unverändert bleibt. Wenn sich der Schweißtransformator der Sättigung nähert, beginnt das Ausgangssignal des Amplitudendemodulators abzusinken. Wenn es einen sättigungsbezogenen Schwellenwert erreicht, dessen Erzeugung weiter unten unter Bezugnahme auf Fig. 9 und die Diskriminatorschaltung 204c beschrieben ist, wird ein in Fig. 6b dargestelltes Blockiersignal erzeugt (Komparator N11 in Fig. 9), das weitere Zündimpulse für die Thyristoren TH1-TH6 (Fig. 3) verhindert. Das Blockiersignal wird an der Klemme c22 in Fig. 9 abgegeben. Der sättigungsbezogene Schwellenwert wird so gewählt, daß eine Sättigung des Kerns 206 mit Sicherheit vermieden wird.

In dem Schaltbild in Fig. 9 sind der Signalfrequenzgenerator 220, das Filter 204a und der Amplitudendemodulator 204b jeweils mit strichpunktierten Linien umrahmt. Diese drei Schaltungselemente brauchen nicht im einzelnen beschrieben zu werden, weil es sich um handelsübliche Schaltungen handelt. Die in der Schaltung nach Fig. 9 verwendeten Bauelemente sind der am Schluß der Beschreibung angegebenen Stückliste zu entnehmen. Außer den genannten Schaltungselementen ist in Fig. 9 die Diskriminatorschaltung 204c dargestellt, die den Komparator N11 enthält und mit der der sättigungsbezogene Schwellenwert eingestellt wird. Das Einstellen dieses Sättigungsschwellenwertes erfolgt an einem einstellbaren Widerstand R104. An diesem Widerstand wird eine Spannung abgegriffen, die an den invertierenden Eingang des Komparators N11 angelegt wird. An dem nichtinvertierenden Eingang 7 des Komparators N11 liegt die Ausgangsspannung des Amplitudendemodulators 204b an. Der Komparator N11 vergleicht beide Spannungen und löst bei Erreichen des Sättigungsschwellenwertes das Blockiersignal (Fig. 6b), aus, das an dem Ausgang c22 erscheint. Zwei parallel geschaltete Dioden V101 und V102 sind auf in Fig. 9 dargestellte Weise einerseits über Inverter V3 mit dem Ausgang des Komparators N11 und andererseits über einen Widerstand R105 mit dem invertierenden Eingang des Komparators N11 verbunden. Mit dieser Schaltung wird eine Hysterese erzeugt, damit der Sättigungsschwellenwert, der die Sättigungsüberwachungsanordnung zum Ansprechen bringt, größer ist als derjenige, der sie wieder unwirksam macht. Anderenfalls könnte sich ein schwingungsfähiger Zustand ergeben.

Die Hysterese wird folgendermaßen erzeugt. Die Einstellung des Widerstands R104 legt eine bestimmte Referenzspannung fest, bei der die Sättigungsüberwachungsanordnung ansprechen soll.

5

Wenn sie angesprochen hat, wird diese Referenzspannung erhöht, damit der Schwellenwert für das Ausschalten (rechte Flanke des Blockiersignals in Fig. 6b) nicht der gleiche ist wie für das Einschalten. Die von dem Widerstand R104 gelieferte Referenzspannung an dem invertierenden Eingang 6 des Komparators N11 bleibt zunächst gleich, wogegen die an dem nichtinvertierenden Eingang 7 des Komparators N11 anliegende Meßspannung mit zunehmender Annäherung an den Sättigungsbereich sinkt und unter die Referenzspannung abnimmt. Wenn die Meßspannung die Referenzspannung unterschreitet, gibt der Komparator N11 das Binärsignal null ab, das durch den der Ausgangsklemme c22 vorgeschalteten Invertierer V3 in ein Binärsignal eins umgewandelt wird. Das gleiche Signal eins liegt auch an den Dioden V101 und V102 an und wird über den Widerstand R105 an den Referenzspannungseingang 6 des Komparators angelegt, wodurch nach dem Ansprechen der Sättigungsüberwachungsanordnung die Referenzspannung höher ist. Da die Referenzspannung nun höher ist, muß die Sättigung niedriger sein, um dieses Signal wieder in den Grundzustand zu schalten, und zwar niedriger als diejenige Sättigung, die das Ansprechen bewirkt hat. Somit liegt die Referenzspannung, die angezeigt hat, daß der Sättigungsschwellenwert erreicht und das Blockiersignal erzeugt wurde, etwas niedriger als diejenige Spannung, die dann anzeigt, daß der Sättigungsschwellenwert wieder unterschritten worden ist. Auf diese Weise kann der Schweißstrom auf jeden Fall sicher abgeschaltet und außerdem bei Bedarf verhindert werden, daß der nächste Thyristor gleich wieder gezündet wird.

Im folgenden wird nun unter Bezugnahme auf die Fig. 1, 7 und 8 beschrieben, wie die Sättigungsüberwachungsanordnung eine herkömmliche Steuerung einer Frequenzwandler-Schweißmaschine beträchtlich vereinfacht und verbessert. Der Benützer der Schweißmaschine stellt über eine Bedienungstafel mit Codierschaltern oder über eine Dialogkonsole den gewünschten Schweißablauf ein. Dazu muß eine Reihe verschiedener Steuerparameter eingestellt werden, oder, wenn eine Mikrosteuerung vorhanden ist, vorprogrammiert sein. Für den einfachsten Fall der herkömmlichen Steuerung sind das die Druckparameter (Vorpreßzeit, Nachpreßzeit und Abhebezeit von jeweils 0... 99 Perioden), und die Stromparameter, nämlich die Schweißzeit $t_s'$ (Fig. 1b) von 0... 7 Perioden, die Pausenzeit von 1... 99 Perioden, die Impulszahl von 1... 999 Perioden, der Anfangsstrom $I_A$ (Fig. 1a) von 30... 95 %, die Anstiegszeit $t_A$ (Fig. 1a) von 0... 79 Perioden und der Schweißstrom $I_s$ von 30... 99 %. Alle Zeiten werden dabei in Perioden gemessen, d. h. in Perioden der Netzfrequenz. Für das folgende Beispiel werden nur die Stromparameter betrachtet und angenommen, daß zwischen den Schweißstromimpulsen keine Pausenzeiten liegen (Fig. 1b).

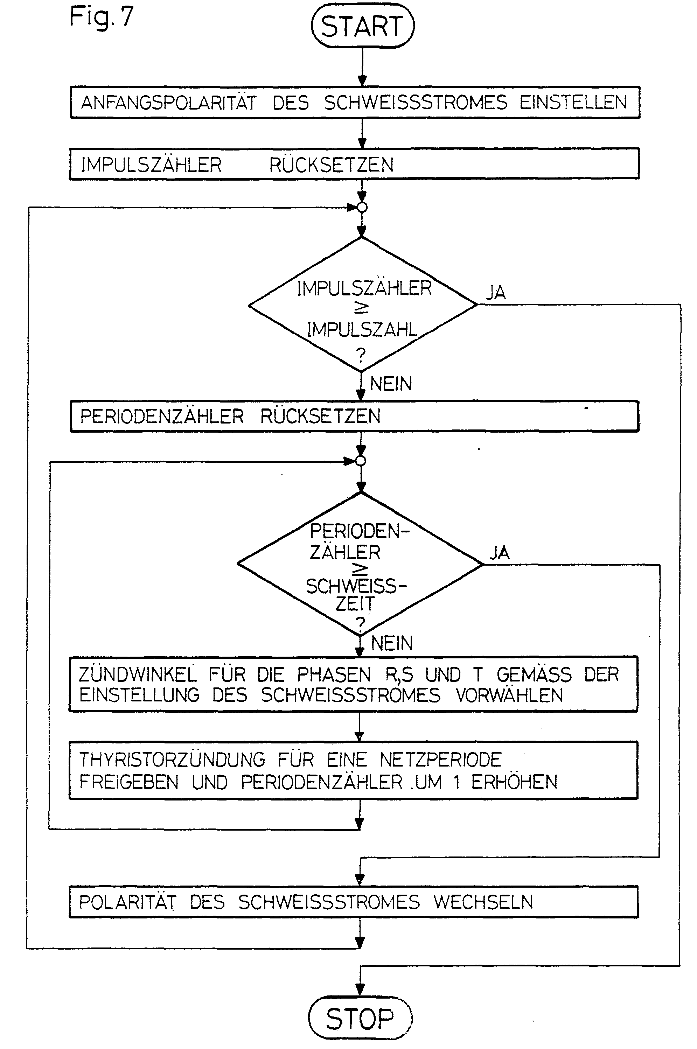

Bei dem herkömmlichen Steuerverfahren wird gemäß dem Mindestprogramm nach Fig. 7 durch den Maschinenbenutzer die Anfangspolarität des Schweißstromes eingestellt. Außerdem hat er eine bestimmte Anzahl von Schweißimpulsen einzustellen (in dem Beispiel in Fig. 1b sind es drei Schweißimpulse). Ein in dem Steuergerät 202 enthaltener Impulszähler, der zunächst rückgesetzt wird, stellt fest, ob die eingestellte Impulszahl bereits abgearbeitet worden ist oder nicht. Wenn das nicht der Fall ist, wird der Periodenzähler rückgesetzt, damit dieser durch Zählung der Netzperioden für einen Schweißimpuls feststellen kann, ob die eingestellte Schweißzeit $t_s'$ bereits erreicht ist oder nicht. Da er auf null rückgesetzt wurde, ist noch keine Schweißzeit abgearbeitet, weshalb das Ergebnis NEIN lautet. Gemäß der Einstellung des Schweißstroms wird nun der Zündwinkel für die Phasenanschnittsteuerung eingestellt, damit der gewünschte Schweißstrom erreicht werden kann. Dann wird die Thyristorzündung für eine Netzperiode freigegeben und der Periodenzähler um eins erhöht, weil die Freigabe für eine Periode erfolgt ist. Danach prüft der Periodenzähler wieder, ob die Schweißzeit bereits erreicht ist. Das ist wiederum nicht der Fall, es wird wieder ein Zündimpuls erzeugt, der Periodenzähler wird wieder um eins erhöht, usw., bis der Periodenzähler feststellt, daß die Schweißzeit $t_s'$ zu Ende ist. Die Abfrage an dem Periodenzähler ergibt dann JA, was bewirkt, daß die Polarität des Schweißstromes gewechselt wird. Der Periodenzähler wird wieder rückgesetzt, und der gleiche Vorgang spielt sich für einen Schweißimpuls entgegengesetzter Polarität ab.

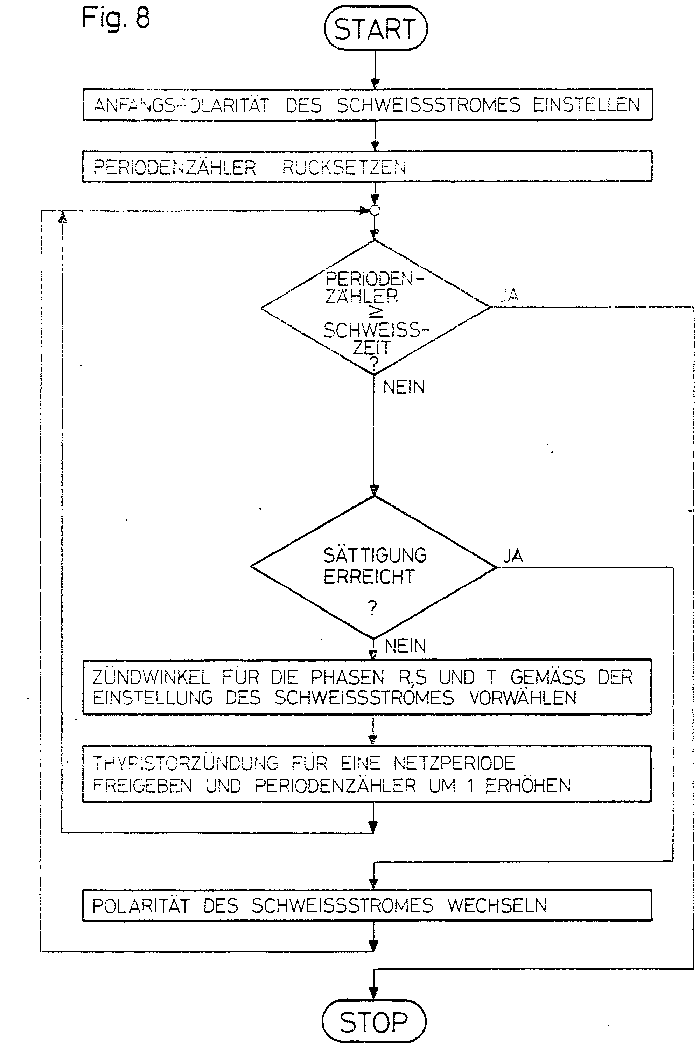

Das Flußdiagramm in Fig. 8 hat im wesentlichen den gleichen Aufbau wie das Flußdiagramm in Fig. 7, nur entfällt hier der Impulszähler, weil als Schweißzeit nicht die Zeit $t_s'$ eines Teilschweißimpulses angenommen wird, sondern die gesamte Schweißzeit $t_s$ (vgl. die Fig. 1a und 1b). Außerdem wird nach dem Vergleich des Periodenzählerinhalts mit der Schweißzeit stets festgestellt, ob der Sättigungsschwellenwert bereits erreicht ist oder nicht. Diese unter Berücksichtigung der Sättigungsüberwachung arbeitende Steuerung hat somit forgenden Ablauf.

Zunächst wird wieder die Anfangspolarität des Schweißstromes eingestellt (der Schweißstrom $I_s$ selbst wird später durch den Zündwinkel eingestellt). Der Periodenzähler wird auf null rückgesetzt. Da sein Inhalt null ist, also kleiner als die eingestellte Schweißzeit, lautet die Antwort NEIN. Die Frage, ob die Sättigung erreicht ist, ist ebenfalls mit NEIN zu beantworten, weil der Schweißvorgang noch nicht begonnen hat. Dann wird der Zündwinkel für die Phasen R, S und T gemäß der Einstellung des Schweißstromes vorgewählt, in diesem Schritt also der Schweißstrom $I_s$ eingestellt. Die Thyristorzündung wird für eine Netzperiode freigegeben, so daß nun der Schweißstrom für eine Netzperiode fließt, und der Periodenzähler wird um eins erhöht. Die Prüfung, ob die Sättigung erreicht ist, ergibt wieder NEIN, weil nach einer Netzperiode der Sättigungsschwellenwert nicht erreicht worden sein kann. Dann wird erneut für eine Netzperiode geschweißt, usw., bis der Sättigungsschwellenwert erreicht ist.

Der wesentliche Unterschied zwischen der Steuerung nach Fig. 8 und der herkömmlichen Steuerung nach Fig. 7 besteht darin, daß die Schweißimpulslänge nicht mehr auf eine bestimmte Periodenzahl begrenzt wird, sondern daß der Impuls so lang gemacht wird, bis der Schweißtransformator den Sättigungsschwellenwert erreicht. Es wird also mit einer Impulslänge gearbeitet, die der Maschinenbenutzer vorher nicht einzustellen braucht und vorher auch nicht wissen kann.

Wenn ein Schweißimpuls beendet ist, wird die Polarität des Schweißstromes $I_s$ gewechselt. Dann wird mit dem entgegengesetzten Schweißimpuls geschweißt, bis wieder der Sättigungsschwellenwert erreicht ist. Falls das Ende der Schweißzeit vorher erreicht werden sollte, wird das Schweißen selbstverständlich beendet, bevor der Sättigungsschwellenwert erreicht wird. Bei der Steuerung nach Fig. 7 kann der Schweißtransformator unerwünschtermaßen in den Sättigungsbereich gelangen, wenn der Maschinenbenutzer anhand des Sättigungsdiagramms nach Fig. 2 für eine bestimmte Transformatorstufe eine ungeeignete Teilschweißimpulszahl gewählt hat, was eingangs näher dargelegt worden ist. Bei der Steuerung nach Fig. 8 hat der Benutzer in dem gewählten Beispiel lediglich noch den Schweißstrom und die gesamte Schweißzeit $t_s$ einzustellen, und die Aufteilung dieser Schweißzeit auf die Teilimpulse macht dann die Steuerung selbsttätig in Abhängigkeit von der Überwachung des Sättigungsschwellenwertes. Bei diesem Steuerverfahren sind auch keine gleichlangen Teilimpulse mehr erforderlich, denn die Umschaltung von einem Teilimpuls auf den anderen erfolgt stets in Abhängigkeit von dem Sättigungsschwellenwert, so daß nach dem Umschalten von einem ersten auf einen zweiten Impuls der zweite Impuls ohne weiteres länger sein kann als der erste Impuls.

Die in Fig. 6d dargestellte Kurve wurde einem Versuchsaufbau entnommen, weshalb der Schweißstrom $I_s$ nach der Vorderflanke des Blockiersignals (linke Flanke in Fig. 6b) nicht sofort auf null abgesunken ist, obgleich der Sättigungsschwellenwert bereits erreicht wurde. Der Grund liegt darin, daß der zuletzt leitende Thyristor erst dann zu leiten aufhört, wenn der durch ihn fließende Strom auf null abgesunken ist. In dem Versuchsaufbau wurde nur der durch einen Thyristor erzeugte Schweißimpuls untersucht, also im Anschluß an das Abschalten von dessen Zündimpulsen kein weiterer Thyristor mit umgekehrter Polung gezündet. Im praktischen Fall wird nach dem Abschalten der Zündung des leitenden Thyristors der nächste Thyristor mit entgegengesetzter Polarität gezündet, der dann den Strom auf null und in die entgegengesetzte Richtung zieht, so daß der in Fig. 6d zu erkennende Ausschwingvorgang entfällt.

Liste der verwendeten Bauelemente (Schaltung nach Fig. 9)

| Bezugs-<br>zeichen | Benennung/Merkmale | | | |
|---|---|---|---|---|
| C1 | Tantalkondensator | 22µF | 10% | 35V |
| C2 | Tantalkondensator | 22µF | 10% | 35V |
| C3 | Vielschicht Ker.kond. | 10nF | 10% | 50V |
| C4 | Vielschicht Ker.kond. | 22nF | 10% | 50V |
| C6 | Polypropylenkondensat. | 10nF | 1% | 63V |
| C7 | Polypropylenkondensat. | 10nF | 1% | 63V |
| C8 | Polypropylenkondensat. | 10nF | 1% | 63V |
| C9 | Vielschicht Ker.kond.<br>CW30C224M245<br>B37984-J5224-K | 220nF | 10% | 50V |
| C14 | Vielschicht Ker.kond.<br>CW20C473M242<br>B37987-J5473-K | 47nF | 10% | 50V |
| N1 | Operationsverstärker<br>LF411CN | J-FET | | |
| N2 | 4-Fach-Komparator | LM 339 | | |
| N4 | Operationsverstärker<br>LF411CN | J-FET | | |

(Fortsetzung)

| Bezugs-zeichen | Benennung/Merkmale | | | | |
|---|---|---|---|---|---|
| N5 | Operationsverstärker LF411CN | | J-FET | | |
| N6 | Operationsverstärker LF411CN | | J-FET | | |
| N10 | 2-Fach-Operationsverst. | | LM358N | | |
| N11 | Komparator | | MC1556 | | |
| R1 | Metallschichtwid. | 20 | kOHM | 1% | 1/4W |
| R2 | Metallschichtwid. | 20 | kOHM | 1% | 1/4W |
| R3 | Metallschichtwid. | 20 | kOHM | 1% | 1/4W |
| R4 | Kohleschichtwid. | 10 | kOHM | 5% | 1/5W |
| R5 | Kohleschichtwid. | 22 | kOHM | 5% | 1/5W |
| R6 | Kohleschichtwid. | 1 | MOHM | 5% | 1/5W |
| R7 | Kohleschichtwid. | 1,8 | kOHM | 5% | 1/5W |
| R8 | Kohleschichtwid. | 3,9 | kOHM | 5% | 1/5W |
| R9 | Kohleschichtwid. | 150 | kOHM | 5% | 1/5W |
| R10 | Kohleschichtwid. | 1 | kOHM | 5% | 1/5W |
| R11 | Kohleschichtwid. | 6,8 | kOHM | 5% | 1/5W |
| R12 | Kohleschichtwid. | 27 | OHM | 5% | 1/5W |
| R13 | Kohleschichtwid. | 27 | OHM | 5% | 1/5W |
| R14 | Kohleschichtwid. | 100 | OHM | 5% | 1/5W |
| R21 | Metallschichtwid. | 47 | kOHM | 1% | 1/4W |
| R22 | Metallschichtwid. | 2,2 | kOHM | 1% | 1/4W |
| R23 | Metallschichtwid. | 2,2 | kOHM | 1% | 1/4W |
| R24 | Metallschichtwid. | 2,2 | kOHM | 1% | 1/4W |
| R25 | Metallschichtwid. | 2,2 | kOHM | 1% | 1/4W |
| R26 | Metallschichtwid. | 5,6 | kOHM | 1% | 1/4W |
| R27 | Metallschichtwid. | 47 | kOHM | 1% | 1/4W |
| R28 | Metallschichtwid. | 47 | kOHM | 1% | 1/4W |
| R29 | Metallschichtwid. | 10 | kOHM | 1% | 1/4W |
| R30 | Metallschichtwid. | 10 | kOHM | 1% | 1/4W |
| R31 | Metallschichtwid. | 4,7 | kOHM | 1% | 1/4W |
| R32 | Metallschichtwid. | 10 | kOHM | 1% | 1/4W |
| R33 | Metallschichtwid. | 10 | kOHM | 1% | 1/4W |
| R47 | Metallschichtwid. | 15 | kOHM | 1% | 1/4W |
| R48 | Metallschichtwid. | 680 | OHM | 1% | 1/4W |
| R49 | Kohleschichtwid. | 100 | kOHM | 5% | 1/5W |
| R50 | Kohleschichtwid. | 100 | kOHM | 5% | 1/5W |
| R69 | Metallschichtwid. | 10 | kOHM | 1% | 1/4W |
| R101 | Metallschichtwid. | 390 | OHM | 1% | 1/4W |

(Fortsetzung)

| Bezugs-zeichen | Benennung/Merkmale | | | | |
|---|---|---|---|---|---|
| R102 | Drahtpotentiometer | 1 | kOHM | 1% | 1/4W |
| R103 | Metallschichtwid. | 2 | kOIIM | 1% | 1/4W |
| R104 | Drahtpotentiometer | 1 | kOHM | .1% | 1/4W |
| R105 | Metallschichtwid. | 1 | kOHM | 1% | 1/4W |
| V1 | Kleinsignaltransistor 1N4448 / BAX 13 | NPN | 50V | 4nS | |
| V6 | Schnelle Diode 1N4448 / BAX 13 | 75mA | 50V | 4nS | |
| V7 | Schnelle Diode 1N4448 / BAX 13 | 75mA | 50V | 4nS | |
| V101 | Diode 1N4148 / BAX 13 | | | | |
| V102 | Diode 1N4148 / BAX 13 | | | | |

## Patentansprüche

1. Anordnung für eine Frequenzwandler-Schweißeinrichtung zur Überwachung der Sättigung des Schweißtransformators, der aus durch ein Steuergerät gesteuerten Leistungshalbleitern positive und negative Stromimpulse empfängt und einen Kern mit drei Schenkeln aufweist, von denen der Mittelschenkel die Primär- und die Sekundärwicklung trägt, gekennzeichnet durch eine Meßwicklung (208), die auf zwei von dem Mittelschenkel (206a) ausgehende Joche (206c) aufgeteilt ist und deren beide Meßwicklungsteile (208', 208") in Reihe geschaltet sind, durch einen an die Meßwicklung (208) angeschlossenen Generator (220) zum Erzeugen einer Meßspannung bestimmter Frequenz und durch eine parallel zu dem Generator (220) an die Meßwicklung (208) angeschlossene Detektorschaltung (204), die zur Erzeugung eines die Ansteuerung der Leistungshalbleiter (TH1-TH6) blockierenden Signals (Fig. 6b) durch einen Vergleich zwischen der Meßspannung und einer Referenzspannung feststellt, wann der induktive Widerstand der Meßwicklung (208) einen auf die Sättigung bezogenen Schwellenwert unterschreitet.

2. Anordnung nach Anspruch 2, dadurch gekennzeichnet, daß der Generator (220) ein Signalfrequenzgenerator ist und eine Rechteckspannung mit einer Frequenz in einem Bereich von 5 bis 20 kHz erzeugt.

3. Anordnung nach Anspruch 2, dadurch gekennzeichnet, daß der Signalfrequenzgenerator (220) eine Rechteckspannung mit einer Frequenz von 10 kHz erzeugt.

4. Anordnung nach einem der Ansprüche 1 bis 3, dadurch gekennzeichnet, daß die Detektorschaltung (204) aus einem Filter (204a), einem Amplitudendemodulator (204b) und einer Diskriminatorschaltung (204c) besteht.

5. Anordnung nach den Ansprüchen 3 und 4, dadurch gekennzeichnet, daß das Filter alle Frequenzen ab 1 kHz durchläßt.

6. Anordnung nach Anspruch 4 oder 5, gekennzeichnet durch eine an die Diskriminatorschaltung (204c) angeschlossene Hystereseschaltung (V101, V102, R105) zum Erhöhen einer dem Schwellenwert des induktiven Widerstandes der Meßwicklung (208) entsprechenden Referenzspannung nach jedem Erreichen des Schwellenwertes.

7. Anordnung nach Anspruch 6, dadurch gekennzeichnet, daß die Diskriminatorschaltung (204c) einen Komparator (N11) enthält, dessen nichtinvertierender Eingang mit dem Ausgang (5) des Amplitudendemodulators (204b) verbunden ist, dessen invertierender Eingang mit einem Spannungsteiler (R103, R104) zum Einstellen der dem Schwellenwert entsprechenden Referenzspannung verbunden ist und dessen Ausgang sowohl mit dem Steuergerät (202) als auch über eine Dioden- und Widerstandsschaltung (V101, V102, R105) mit seinem invertierenden Eingang verbunden ist.

8. Verfahren zur Steuerung einer Frequenzwandler-Schweißeinrichtung, dadurch gekennzeichnet, daß eine Anordnung nach einem der Ansprüche 1 bis 7 verwendet wird, daß die gesamte Schweißzeit für

ein Schweißspiel gleichstrommäßig vorgewählt wird und daß sowohl beim Ein- als auch beim Mehrimpulsschweißen der Schweißstrom innerhalb der vorgewählten Schweißzeit stets bis zum Erreichen des sättigungsbezogenen Schwellenwertes erzeugt wird.

## Claims

1. An arrangement for a frequency-converter welding device to monitor the saturation of the welding transformer which receives positive and negative current impulses from power semiconductors controlled by a control unit and which comprises a core with three legs of which the middle leg carries the primary winding and the secondary winding, characterised by a measuring winding (208) which is distributed over two yokes (206c) originating from the middle leg (206a) and the two measuring-winding parts (208', 208") of which are connected in series, by a generator (220) connected to the measuring winding (208) to generate a measuring voltage of a specific frequency and by a detector circuit (204) which is connected to the measuring winding (208) in parallel to the generator (220) and which determines, by a comparison between the measuring voltage and a reference voltage, when the inductive resistance of the measuring winding (208) drops below a threshold value related to saturation, in order to generate a signal (Figure 6b) blocking the drive of the power semiconductors (TH1-TH6).

2. An arrangement as claimed in Claim 1, characterised in that the generator (220) is a signal frequency generator and generates a rectangular voltage with a frequency in a range from 5 to 20 kHz.

3. An arrangement as claimed in Claim 2, characterised in that the signal frequency generator (220) generates a rectangular voltage with a frequency of 10 kHz.

4. An arrangement as claimed in one of the Claims 1 to 3, characterised in that the detector circuit (204) consists of a filter (204a), an amplitude demodulator (204b) and a discriminator circuit (204c).

5. An arrangement as claimed in Claims 3 and 4, characterised in that the filter transmits all frequencies beyond 1 kHz.

6. An arrangement as claimed in Claim 4 or 5, characterised by a hysteresis circuit (V101, V102, R105) connected to the discriminator circuit (204c) to increase a reference voltage corresponding to the threshold value of the inductive resistance of the measuring winding (208) after each time the threshold value is reached.

7. An arrangement as claimed in Claim 6, characterised in that the discriminator circuit (204c) contains a comparator (N11), the non-inverting input of which is connected to the output (5) of the amplitude demodulator (204b) while its inverting input is connected to a voltage divider (R103, R104) to adjust the reference voltage corresponding to the threshold value and the output of which is connected both to the control unit (202) and to its inverting input through a diode and resistor circuit (V101, V102, R105).

8. A method of controlling a frequency-converter welding device, characterised in that an arrangement as claimed in one of the Claims 1 to 7 is used, that the total welding time for a welding cycle is preselected as far as direct current is concerned and that within the preselected welding time, the welding current is always produced until the threshold value related to saturation is reached, both during single-impulse and during multi-impulse welding.

## Revendications

1. Dispositif de surveillance de la saturation d'un transformateur de soudage pour une installation de soudage comportant un changeur de fréquence, le transformateur de soudage recevant des impulsions positives et négatives de semi-conducteurs de puissance commandés par un dispositif de commande et comprenant un noyau pourvu de trois branches dont la branche intermédiaire porte les enroulements des circuits primaire et secondaire, caractérisé en ce qu'il comprend un enroulement de mesure (208) qui est réparti sur deux des culasses (206c) s'étendant à partir de la branche intermédiaire (206a) et dont les deux parties d'enroulement de mesure (208', 208") sont connectées en série, un générateur (220) relié à l'enroulement de mesure (208) afin de produire une tension de mesure d'une fréquence déterminée, et un montage de détection (204) relié à l'enroulement de mesure (208) en parallèle avec le générateur (220), le montage de détection déterminant par une comparaison entre la tension de mesure et une tension de référence, le moment où l'inductance de l'enroulement de mesure (208) baisse au-dessous d'une valeur de seuil correspondant à la saturation, afin de produire un signal bloquant la commande des semi-conducteurs de puissance (TH1-TH6) (figure 6b).

2. Dispositif suivant la revendication 1, caractérisé en ce que le générateur (220) est un générateur de fréquence de signaux prosuidant une tension rectangulaire ayant une fréquence dans une gamme de 5 à 20 kHz.

3. Dispositif suivant la revendication 2, caractérisé en ce que le générateur de fréquence de signaux (220) produit une tension rectangulaire d'une fréquence de 10 kHz.

4. Dispositif suivant l'une des revendications 1 à 3, caractérisé en ce que le montage de détection (204) est constitué d'un filtre (204a), d'un démodulateur d'amplitude (204b) et d'un montage de discrimination (204c).

5. Dispositif suivant les revendications 3 et 4, caractérisé en ce que le filtre laisse passer toutes les fréquences à partir de 1 kHz.

6. Dispositif suivant la revendication 4 ou 5, caractérisé en ce qu'il comporte un montage à hystérésis (V101, V102, R105) connecté au montage de discrimination (204c) et destiné à augmenter une tension de référence correspondant à une valeur de seuil de l'inductance de l'enroulement de mesure (208) chaque fois que cette valeur de seuil est atteinte.

7. Dispositif suivant la revendication 6, caractérisé en ce que le montage de discrimination (204c) comporte un comparateur (N11) dont l'entrée non inverseuse est reliée à la sortie (5) du démodulateur d'amplitude (204b), dont l'entrée inverseuse est reliée à un diviseur de tension (R103, R104) pour le réglage de la tension de référence correspondant à la valeur de seuil, et dont la sortie est reliée au dispositif de commande (202) ainsi qu'à l'entrée inverseuse par l'intermédiaire d'un montage à diodes et à résistance (V101, V102, R105).

8. Procédé pour la commande d'une installation de soudage comprenant un changeur de fréquence, caractérisé en ce qu'un dispositif suivant l'une des revendications 1 à 7 est utilisé, en ce que le temps de soudage total est présélectionné, comme pour un courant continu, pour un cycle de soudage et en ce que, lors d'un soudage à une ou plusieurs impulsions, le courant de soudage est produit pendant le temps de soudage présélectionné jusqu'à ce que la valeur de seuil correspondant à la saturation soit atteinte.

Fig. 1a

Fig. 1b

Fig. 1c

Fig. 2

Maximale Schweiss-Strom-Aussteuerung

( Sättigungs-Diagramm )

Schweiss-Strom-
Aussteuerung in ‰

Stufe 1/Serie
Stufe 2/Serie

Stufe 3/Serie

Stufe 1/ II

Stufe 2/ II

Stufe 3/ II

Schweisszeit in Perioden

0 191 178

2

gemessen mit offenem Sekundär-Kreis
Grundlast-Widerstand: $2 \times 9\,\Omega$  II = 4,5 $\Omega$

Fig.3

Fig. 4

## Fig. 5

## Fig.6

**0 191 178**

Fig. 7

$$\boxed{(\text{START})}$$

ANFANGSPOLARITÄT DES SCHWEISSSTROMES EINSTELLEN

IMPULSZÄHLER RÜCKSETZEN

IMPULSZÄHLER ≥ IMPULSZAHL ? — JA

NEIN

PERIODENZÄHLER RÜCKSETZEN

PERIODEN-ZÄHLER ≥ SCHWEISS-ZEIT ? — JA

NEIN

ZÜNDWINKEL FÜR DIE PHASEN R,S UND T GEMÄSS DER EINSTELLUNG DES SCHWEISSSTROMES VORWÄHLEN

THYRISTORZÜNDUNG FÜR EINE NETZPERIODE FREIGEBEN UND PERIODENZÄHLER UM 1 ERHÖHEN

POLARITÄT DES SCHWEISSSTROMES WECHSELN

$$\boxed{(\text{STOP})}$$

7

# Fig. 8

START

ANFANGSPOLARITÄT DES SCHWEISSSTROMES EINSTELLEN

PERIODENZÄHLER RÜCKSETZEN

PERIODEN-ZÄHLER ≥ SCHWEISS-ZEIT ? — JA

NEIN

SÄTTIGUNG ERREICHT ? — JA

NEIN

ZÜNDWINKEL FÜR DIE PHASEN R,S UND T GEMÄSS DER EINSTELLUNG DES SCHWEISSSTROMES VORWÄHLEN

THYRISTORZÜNDUNG FÜR EINE NETZPERIODE FREIGEBEN UND PERIODENZÄHLER UM 1 ERHÖHEN

POLARITÄT DES SCHWEISSSTROMES WECHSELN

STOP

8

## 0 191 178

### Fig. 9